(19) Europäisches Patentamt
European Patent Office
Office européen des brevets

(11) **EP 3 316 005 A1**

(12) **EUROPEAN PATENT APPLICATION**

(43) Date of publication:
**02.05.2018 Bulletin 2018/18**

(51) Int Cl.:
*G01V 3/02* *(2006.01)* *H03K 17/0814* *(2006.01)*
*G01V 11/00* *(2006.01)*

(21) Application number: **17198405.7**

(22) Date of filing: **25.10.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **25.10.2016 IT 201600107518**

(71) Applicant: **Harus S.R.L.**
**00046 Grottaferrata (IT)**

(72) Inventors:
• **CORRADI, Giovanni**
**00046 Grottaferrata (IT)**
• **COLADO, Francesco**
**00046 Grottaferrata (IT)**
• **FEDERICI, Gianni**
**00046 Grottaferrata (IT)**

(74) Representative: **Bergadano, Mirko et al**
**Studio Torta S.p.A.**
**Via Viotti, 9**
**10121 Torino (IT)**

(54) **GEOELECTRIC PROSPECTION**

(57)    A geoelectrical prospection apparatus (1) comprising:
- current electrodes (A, B) and voltage electrodes (M, N) adapted to be arranged in contact with a medium;
- an electric power supply device (3), to which the current electrodes (A, B) are selectively connected so as to be electrically powered and to inject an electric current into the medium;
- a measurement device (2), to which the voltage electrodes (M, N) are selectively connected to measure and analogical-to-digital convert the geoelectrical measurements defined by differences V(i,j) between the electric potentials of the voltage electrodes (M, N) connected to the measurement device (2) and induced by the electric current injected into the medium by the current electrodes (A, B) connected to the electric power supply device (3); and
- an electronic control unit (4) connectable to the electric power supply device (3) and to the measurement device (2) to control the operation of the electric power supply device (3) and to receive, from the measurement device (2), and process the electric potentials of the voltage electrodes (M, N) connected to the measurement device (2) to determine a geoelectrical model of the medium.

The measurement device (2) comprises an analog-to-digital converter (5) having an analog front-end input configured to receive the electric potentials of the voltage electrodes (M, N), connected to the measurement device (2), and to be supplied with a power supply electric potential (+V) with respect to a reference electric potential (Vcom).

The geoelectrical prospection apparatus (1) is characterized in that the measurement device (2) is configured to supply the analog front-end input of the analog-to-digital converter (5) with the electric potentials of the voltage electrodes (M, N) connected to the measurement device (2) so as to result in the reference electric potential (Vcom) being floating with respect to electric potentials induced between the voltage electrodes (M, N), whereby the difference V (i,j) between the electric potentials induced between any of two voltage electrodes i and j is equal to:

$$V(i,j) = V(i,com) - V(j,com)$$

where V(i,com) is the difference between the electric potential of the voltage electrode i and the reference potential V(com), and V(j,com) is the difference between the electric potential of the voltage electrode j and the reference potential V(com), which resultingly fails to intervene in the determination of the difference V(i,j) between the electric potentials of the voltage electrodes i and j.

EP 3 316 005 A1

equipotential surfaces          current lines

# FIG. 1

## Description

### Technical Field of the Invention

The present invention relates to geoelectrical prospection by means of multi-electrode resistivity measurements.

### State of the Art

As is known, geoelectrical prospection is one of the most used geophysical methods or studying the subsurface through the analysis of the electrical properties thereof. In particular, the aim of geoelectrical prospection is to reconstruct an apparent subsurface resistivity model by measuring the electric voltage at various points of the subsurface.

The apparent subsurface resistivity is a complex function of porosity, permeability, ionic content of the retention fluids, and argillaceous mineralization, and is measured by injecting a direct electric current into the subsurface by means of two or more electrodes, known as current or injection electrodes, and measuring the electric voltage created by the circulation of the injected electric current by means of other electrodes, known as voltage or measuring electrodes, appropriately arranged and/or embedded in the ground.

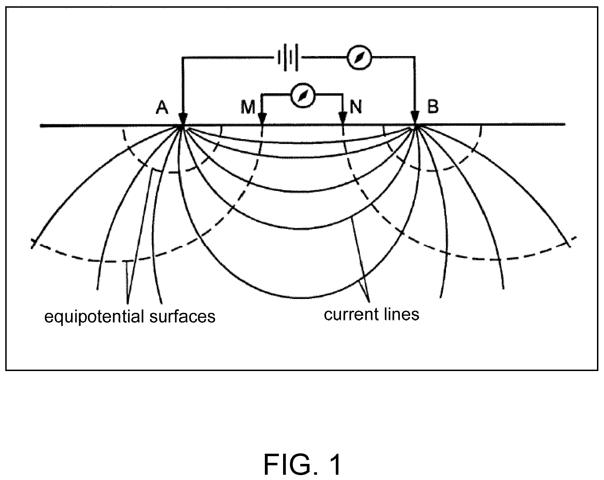

The apparent subsurface resistivity measurement principle is shown in Figure 1, where the current electrodes are denoted by A and B, and the voltage electrodes are denoted by M and N.

The electrodes are usually bronze, copper or stainless steel 45 to 50 cm long stakes, that are sunk into the ground to produce a good contact and provided with connection jacks.

The distribution of the electric potential in the subsurface, obtained from the voltage measurements, enables reconstructing the trend of the electric current in the subsurface, and therefore also the geometry of the various areas of the subsurface with different electrical resistivity, which can be due, for example, to differences in composition or structure, the presence of water, foreign bodies, hollows or other discontinuities.

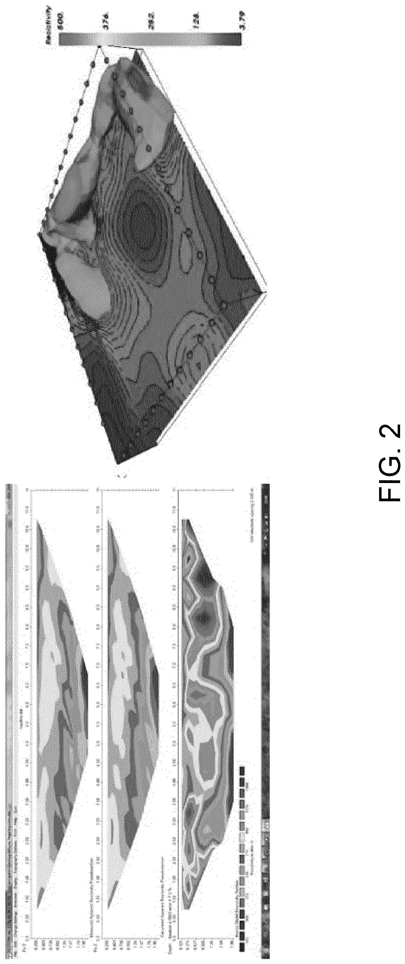

Several geoelectrical prospection apparatuses are known, also known as geo-resistivity meters or electrical tomography apparatuses, which basically comprose an electric energy source, such as a battery or an electricity generator, current and voltage electrodes, an instrument for measuring the intensity of the electric current injected into the ground via the current electrodes and the induced electric voltage between the voltage electrodes (geoelectrical measurements), and an electronic control and processing unit programmed to appropriately control the electric energy source so as to appropriately control the supply of electric energy to the current electrodes, as well as receiving, appropriately conditioning and processing the geoelectrical measurements by means of a specific, so-called geoelectrical inversion software, so as to produce a representation of the subsurface based on the apparent subsurface resistivity in the form of a conventional colour-coded map, shown in Figure 2, where a two-dimensional reconstruction of the subsurface along a cross-section is shown on the left and a three-dimensional reconstruction of the subsurface is shown on the right.

US 2014/218037 A1 discloses a system for spectral induced polarization measurement of a formation. The system provides an intelligent module to be utilized in performing spectral induced polarization (SIP) measurements for geophysical studies or otherwise. The system includes a instrument that includes a housing configured to be inserted into a surface opening. The housing houses a signal generator that generates an excitation signal. A drive electrode directs the excitation signal into the material adjacent the housing. A plurality of electrodes sense the voltage and/or current in the material adjacent the housing and a processor processes the sensed voltage and/or current to measure a property of the material. The system also provides a configuration in which a plurality of instruments configured for spectral induced polarization measurements are interconnected to provide communication, synchronization, a common reference signal or power.

US 2008/136421 A1 discloses a method and an apparatus for detecting and transmitting geophysical data from a plurality of electrodes inserted into the soil utilizing a set of identical dynamically reconfigurable voltage control units located on each electrode and connected together by a communications and power cable. A test sequence is provided in each voltage control unit. Each voltage control unit records data measurements for transmission to a central data collector. Each voltage control unit incorporates and determines its positional relationship to other voltage control units by logging when the unit is attached to the electrode. Each voltage control unit I equipped with a magnetic switch for detecting when they are in contact with the electrode.

US 2006/055418 A1 discloses a measurement system for measuring subsurface resistivity, wherein the surfaces of interest are, for example, engineered surfaces such as roads and dams, and non-engineered surfaces such as greenfield sites. The measurement system may also be used on biological materials. The system includes signal input electrodes for inputting an input signal into subsurface material by capacitive coupling. Pairs of signal detection electrodes allow capacitive coupling detection of a detectable signal caused by the input signal in at least some of the subsurface material. A phase-sensitive meter such as a lock-in amplifier is provided to measure the amplitude and phase of the detectable signal.

## Object and Summary of the Invention

The object of the present invention is to improve the sensitivity of the above-described geoelectrical prospection apparatuses, bringing it to the technological limit through both hardware and software innovations, so as to able to better analyse the depths and to study water tables and anything else at depth in greater detail.

According to the present invention, a geoelectrical prospection apparatus is provided, as claimed in the appended claims.

## Brief Description of Drawings

Figure 1 shows the principle of operation of a geoelectrical prospection apparatus.

Figure 2 shows a conventional colour-coded map obtained by inversion of geoelectrical measurements, with a two-dimensional reconstruction along a cross-section (on the left) and a three-dimensional reconstruction (on the right).

Figure 3 shows a general schematic of the geoelectrical prospection apparatus of the present invention.

Figures 4a and 4b show a conventional layout of a relay matrix used to select the desired channels in the analog-to-digital conversion of geoelectrical measurements.

Figures 5a and 5b show an innovative layout according to the present invention used to read and analog-to-digital convert geoelectrical measurements.

Figure 6 shows a circuit diagram of a signal conditioning stage of an analog front-end for a conversion channel.

Figure 7 shows an "active clamp" PWM controller on a programmable power supply board.

Figure 8 shows the temporal trends of two drive signals generated by the PWM controller in Figure 7.

Figure 9 shows the temporal trend of a buffer voltage at the terminals of a buffer capacitor in the PWM controller in Figure 7.

## Detailed Description of Preferred Embodiments of the Invention

The present invention will now be described in detail, with reference to the accompanying drawings, to enable an expert in the field to embody it and use it. Various modifications to the described embodiments will be immediately obvious to experts in the field, and the generic principles described herein can be applied to other embodiments and applications without departing from the scope of protection of the present invention, as defined in the appended claims. Thus, the present invention is not intended to be limited to the embodiments set forth herein, but is to be granted the widest scope of protection consistent with the principles and features described and claimed herein.

The geoelectrical prospection apparatus according to the present invention exhibits a hierarchical and modular architecture, so resulting in the geoelectrical prospection apparatus comprsing, in addition to the traditional current and voltage electrodes, various electronic boards that, although using commercial components, exhibits several interesting design innovations.

In particular, the geoelectrical prospection apparatus according to the present invention comproses the following boards:

1. geoelectrical measurement analog acquisition board, hereinafter referred to as SCA board;

2. Programmable power board, hereinafter referred to as SAP board, and

3. Control board, hereinafter referred to as SCC board, comprising an electronic control unit based on an ARM Cortex-M3 processor (CPU-ARM) and associated novel firmware or software module, that, in addition to controlling various peripherals, real-time processes the geoelectrical measurements to analyses the subsurface structure.

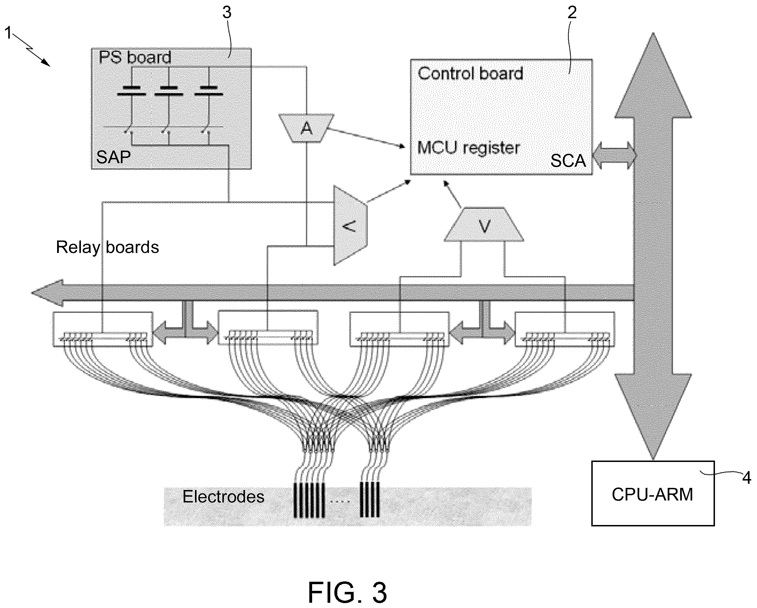

Figure 3 shows a general schematic of the geoelectrical prospection apparatus of the present invention, denoted as a whole by reference numeral 1, also showing the subsystems constituted by the SCA and SAP boards, denoted as a whole by reference numerals 2 and 3, respectively, as well as the CPU-ARM, denoted as a whole by reference numeral 4, which takes care of controlling the various subsystems, exception handling, and also the connection with the outside via commonly used communications protocols.

A brief overview of the functions of each of the above-indicated boards is provided below, pointing out the design innovations implemented.

1. SCA board

The SCA board 2 is connected to the voltage electrodes, which may be arranged up to tens of metres away, dependening on the chosen measurement configuration, via a multicore cable, and has the task of simultaneously acquiring several geoelectrical measurements, with signal adaptation for the analog front-end input of the analog-to-digital converter stage, which analog front-end input is designed to optimize the signal-noise ratio and the transient settling constants.

The geoelectrical measurements are acquired by optimizing the input filters to reject residual noise at 50Hz and 400Hz, which is naturally present in the ground due to electrical network leakage. Analog-to-digital conversion (ADC), the dynamics of which enable having a resolution such as to satisfy the measurement requirements, is performed downstream of signal conditioning. For example, opportune values of resolution and dynamics could be 24-bit and 10 Volt.

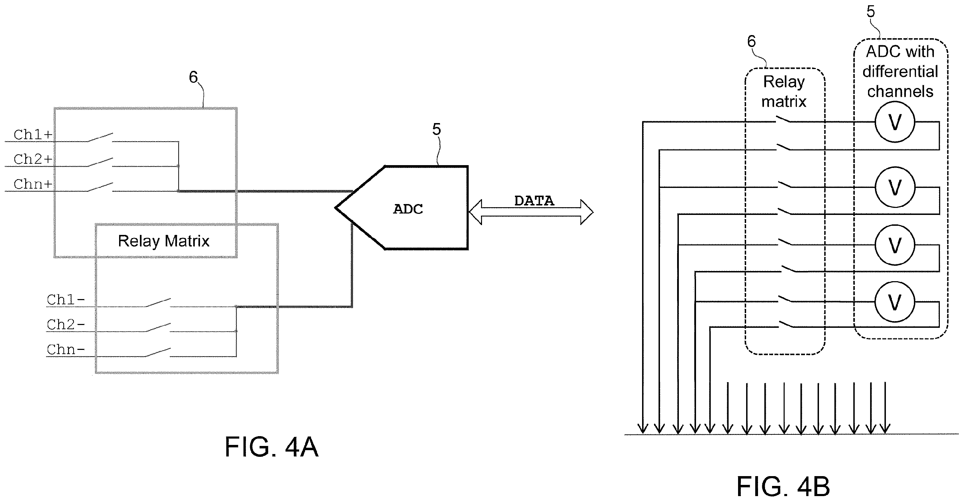

In geoelectrical prospection apparatuses currently on the market, the geoelectrical measurements are analog-to-digital converted in accordance with a conventional scheme shown in Figures 4a and 4b, namely by connecting pairs of voltage electrodes to the analog-to-digital conversion stage, denoted by reference numeral 5, by means of a specially provided relay matrix, denoted by reference numeral 6, through which the geoelectrical measurements (electric voltages) are consequently supplied to the front-end input of the analog-to-digital conversion stage in order for them to be analog-to-digital converted. According to this conventional configuration, each analog-to-digital conversion of a geoelectrical measurement results in the reference electric potential (earth) in the analog-to-digital conversion stage being switched to assume the electric potential (ch-) of one of the voltage electrodes.

This conventional approach involves considerable hardware and software complexity to reconstruct the correct decoding of the position of the voltage electrodes and requires the connection of each pair of voltage electrodes to a pair of inputs of the analog-to-digital conversion stage.

Therefore, one aspect of the present invention is that the reference electric potential in the analog-to-digital conversion stage is not connected to one of the voltage electrodes so as to assume the electric potential assumed by that voltage electrode, but is kept floating.

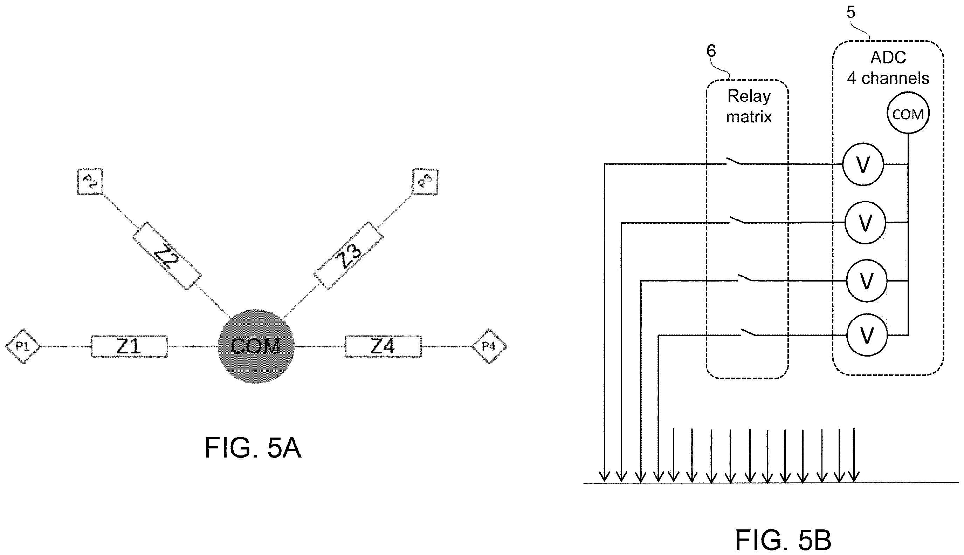

Figures 5a and 5b show schematics of the functional signal conditioning architecture adopted in the SCA board 2 according to the present invention, where for reasons of simplicity of graphical representation, only four electrodes, also refered to as channels, are shown.

It may be appreciated that the relation linking the electric voltage V(i,j) (geoelectrical measurement) across two voltage electrodes i and j is equal to:

$$V(i,j) = V(i,com) - V(j,com)$$

It may also be appreciated that the reference electric potential of the common node V(com) fails to be involved in said relation and, due to the impedances Z (equal to one another), spontaneously moves to the centre of the various V(j)s.

From the foregoing, it may also be appreciated how, given an analog-to-digital conversion stage 5 formed by N analog-to-digital conversion units, the connection scheme according to the present invention enables analog-to-digital conversion of N geoelectrical measurements simultaneously, from which it is then possible to derive other N*(N-1)/2 geoelectrical measurements deriving from the N*(N-1)/2 possible combinations of pairs of voltage electrodes.

The connection between the analog-to-digital conversion units and the voltage electrodes is implemented by means of a relay matrix 6 such as to cause the SCA board 2 to select and simultaneously and sequentially connect a number of voltage electrodes (channels) equal to the number of analog-to-digital conversion units.

A connection scheme of 96 electrodes to 12 analog-to-digital conversion units with a modularity equal to 6 is shown, by way of non-limitative example, in the following table.

| AD1 | 1 | 7 | 13 | 19 | 25 | 31 | 37 | 43 | 49 | 55 | 61 | 67 | 73 | 79 | |
|-----|---|---|----|----|----|----|----|----|----|----|----|----|----|----|---|
| AD2 | 2 | 8 | 14 | 20 | 26 | 32 | 38 | 44 | 50 | 56 | 62 | 68 | 74 | 80 | |
| AD3 | 3 | 9 | 15 | 21 | 27 | 33 | 39 | 45 | 51 | 57 | 63 | 69 | 75 | 81 | |
| AD4 | 4 | 10 | 16 | 22 | 28 | 34 | 40 | 46 | 52 | 58 | 64 | 70 | 76 | 82 | |
| AD5 | 5 | 11 | 17 | 23 | 29 | 35 | 41 | 47 | 53 | 59 | 65 | 71 | 77 | 83 | |
| AD6 | 6 | 12 | 18 | 24 | 30 | 36 | 42 | 48 | 54 | 60 | 66 | 72 | 78 | 84 | |
| AD7 | | 13 | 19 | 25 | 31 | 37 | 43 | 49 | 55 | 61 | 67 | 73 | 79 | 85 | 91 |
| AD8 | | 14 | 20 | 26 | 32 | 38 | 44 | 50 | 56 | 62 | 68 | 74 | 80 | 86 | 92 |
| AD9 | | 15 | 21 | 27 | 33 | 39 | 45 | 51 | 57 | 63 | 69 | 75 | 81 | 87 | 93 |

(continued)

| AD10 | | 16 | 22 | 28 | 34 | 40 | 46 | 52 | 58 | 64 | 70 | 76 | 82 | 88 | 94 |
| AD11 | | 17 | 23 | 29 | 35 | 41 | 47 | 53 | 59 | 65 | 71 | 77 | 83 | 89 | 95 |
| AD12 | | 18 | 24 | 30 | 36 | 42 | 48 | 54 | 60 | 66 | 72 | 78 | 84 | 90 | 96 |

Conveniently, the connection scheme implemented by the relay matrix 6 is such as to cause the SCA board 2 to select and simultaneously and sequentially connect a number of potential electrodes with a modularity expressed by a number that is relatively prime to the number of simultaneous analog-to-digital conversions (this last number being obviously equal to the number of analog-to-digital conversion units), namely such that the modularity and the number of simultaneous analog-to-digital conversions are coprime or mutually prime integers.

This modularity results in the least number of address conflicts on the channels of the analog-to-digital conversion units, as well as allows the absolute maximum of simultaneous conversions to be obtained and, for each given geoelectrical measurement configuration, also the minimum number of commutations and the absolute minimum time employed for measurement.

A connection scheme of 96 electrodes to 12 analog-to-digital conversion units with a modularity equal to 7 is shown, by way of non-limitative example, in the following table.

| AD1 | 1 | 8 | 15 | 22 | 29 | 36 | 43 | 50 | 57 | 64 | 71 | 78 | |
| AD2 | 2 | 9 | 16 | 23 | 30 | 37 | 44 | 51 | 58 | 65 | 72 | 79 | |
| AD3 | 3 | 10 | 17 | 24 | 31 | 38 | 45 | 52 | 59 | 66 | 73 | 80 | |
| AD4 | 4 | 11 | 18 | 25 | 32 | 39 | 46 | 53 | 60 | 67 | 74 | 81 | |
| AD5 | 5 | 12 | 19 | 26 | 33 | 40 | 47 | 54 | 61 | 68 | 75 | 82 | |
| AD6 | 6 | 13 | 20 | 27 | 34 | 41 | 48 | 55 | 62 | 69 | 76 | 83 | 90 |
| AD7 | 7 | 14 | 21 | 28 | 35 | 42 | 49 | 56 | 63 | 70 | 77 | 84 | 91 |
| AD8 | | 15 | 22 | 29 | 36 | 43 | 50 | 57 | 64 | 71 | 78 | 85 | 92 |
| AD9 | | 16 | 23 | 30 | 37 | 44 | 51 | 58 | 65 | 72 | 79 | 86 | 93 |
| AD10 | | 17 | 24 | 31 | 38 | 45 | 52 | 59 | 66 | 73 | 80 | 87 | 94 |
| AD11 | | 18 | 25 | 32 | 39 | 46 | 53 | 60 | 67 | 74 | 81 | 88 | 95 |
| AD12 | | 19 | 26 | 33 | 40 | 47 | 54 | 61 | 68 | 75 | 82 | 89 | 96 |

A connection scheme of 96 electrodes to 12 analog-to-digital conversion units with a modularity equal to 11 is instead shown, always by way of non-limitative example, in the following table.

| AD1 | | 12 | 23 | 34 | 45 | 56 | 67 | 78 | 89 |
| AD2 | 2 | 13 | 24 | 35 | 46 | 57 | 68 | 79 | 90 |
| AD3 | 3 | 14 | 25 | 36 | 47 | 58 | 69 | 80 | 91 |
| AD4 | 4 | 15 | 26 | 37 | 48 | 59 | 70 | 81 | 92 |
| AD5 | 5 | 16 | 27 | 38 | 49 | 60 | 71 | 82 | 93 |
| AD6 | 6 | 17 | 28 | 39 | 50 | 61 | 72 | 83 | 94 |
| AD7 | 7 | 18 | 29 | 40 | 51 | 62 | 73 | 84 | 95 |
| AD8 | 8 | 19 | 30 | 41 | 52 | 63 | 74 | 85 | 96 |
| AD9 | 9 | 20 | 31 | 42 | 53 | 64 | 75 | 86 | |
| AD10 | 10 | 21 | 32 | 43 | 54 | 65 | 76 | 87 | |
| AD11 | 11 | 22 | 33 | 44 | 55 | 66 | 77 | 88 | |

(continued)

| AD12 | 12 | 23 | 34 | 45 | 56 | 67 | 78 | 89 | |
|------|----|----|----|----|----|----|----|----|--|

A further consequence of the proposed connection scheme is that it results in the relay switching board comprising the minimum number of components, thereby simplifying the routing and the layout of the relay switching board and reducing cross-talk noise between adjacent channels.

Ultimately, the advantage that the present invention allows to achieve is multi-faceted: (1) the time necessary to complete the acquisition is kept to the minimum, a parameter that is considered to be of significant importance for the three-dimensional reconstruction of geoelectric images, where the number of potential electrodes used, and therefore, the possible number combinations, is much larger than the geoelectrical measurements; (2) the number of components and connections on the relay matrix board is reduced; and (3) the lowest possible loss of connection is achieved, with significant noise reduction and a consequent increase in channel sensitivity.

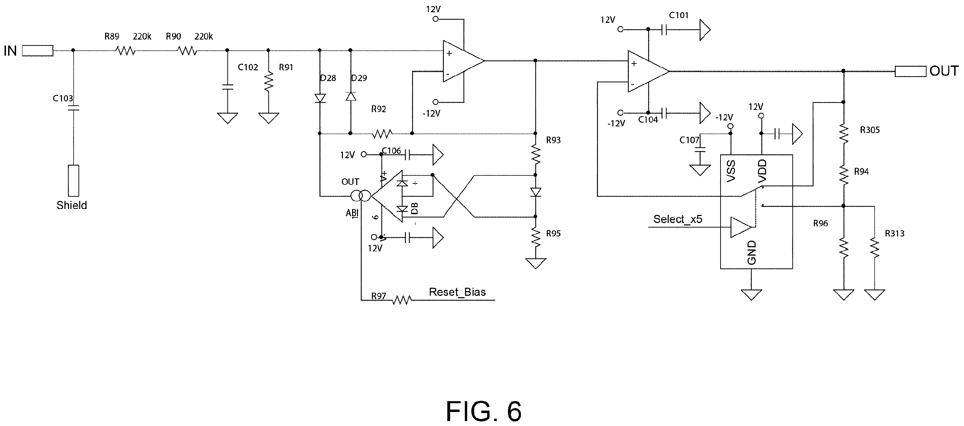

Figure 6 shows, by way of non-limitative example, a possible circuit diagram of the signal conditioning stage of the analog front-end for a conversion channel, wherein an input stage having the integrator function and a reset control of high reliability and stability, followed by a variable gain amplifier stage, are visible. The input stage also has an integrator filter function, to reject low frequency noise and keep the input voltage of the analog-to-digital conversion stage stable during the sampling and conversion phase. In Figure 6, the common electric reference potential, which is kept floating, is represented by the earth connection.

2. <u>SAP board</u>

The SAP board 3 is the one that provides electric energy to the current electrodes and covers a very important role, as it covers the two-fold function of ensuring that the electric voltage supplied to the current electrodes is programmable and stable with respect to load fluctuations, and enabling the reading of the electric voltage and of electric current supplied to the current electrodes, to be sampled simultaneously with the geoelectrical measurements with 24-bit precision.

Stabilization of the electric voltage supplied to the current electrodes with respect to load fluctuations is achieved through pulse width modulation (PWM). In addition, a low-noise electric energy source is used, necessary for maximizing the signal-noise ratio downstream of the high-sensitivity samplers of the signal conditioning stage.

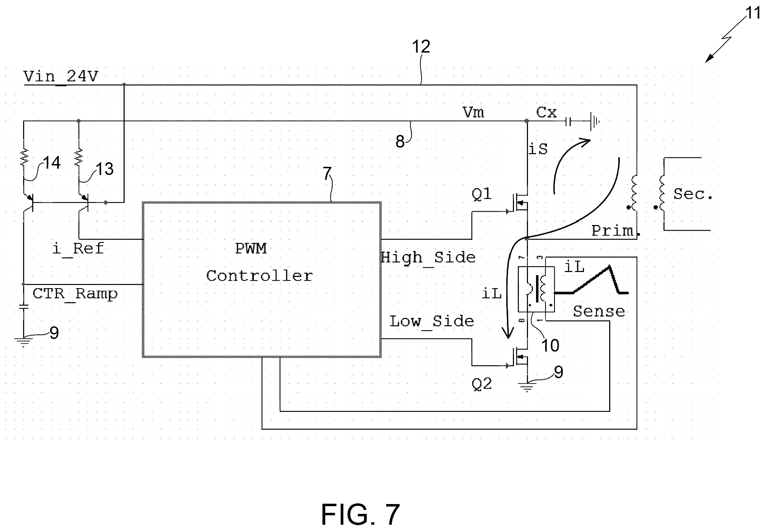

A different aspect of the present invention is that according to which the SAP board 3 is provided with a PWM controller in a so-called "active clamp" configuration, a circuit diagram schematic of which is shown in Figure 7.

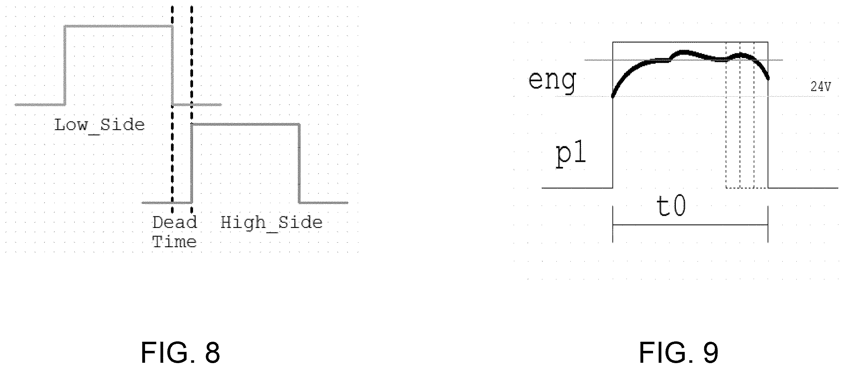

The PWM controller, indicated by reference numeral 7, outputs two square-wave drive signals, referred toas as "High_Side" and "Low_Side", which have the temporal trends shown in Figure 8, and has the function of ON/OFF driving two n-type pull-up and pull-down output Mosfets, denoted by Q1 and Q2, series-connected between a buffer power supply line, denoted by reference numeral 8, set at a buffer electric potential, denoted by Vm in the example shown, and a reference electric line, denoted by reference numeral 9, set at a reference electric potential, the earth's electric potential in the example shown. A buffer capacitor, denoted by Cx, is connected between the buffer power supply line 8 and the reference electric line 9.

As can be observed in Figure 8, the High_Side and Low_Side drive signals are temporally separated by a dwell time such that the Mosfet gates have a time gap to avoid simultaneous activation of the two Mosfets Q1 and Q2 and a resulting rail-to-rail electric current conduction between the buffer power supply line 8 and the reference electric line 9.

A current sensing circuit, denoted by reference numeral 10, is connected between the two output Mosfets Q1 and Q2, which has the function of measuring the electric current flowing between the two Mosfets Q1 and Q2 and feeding it back to the PWM controller 7, which also comprises a transformer, denoted by reference numeral 11, having a primary connected between a power supply input line, denoted by reference numeral 12, set at an input electric potential, 24 V in the example shown, and a common node between the two Mosfets Q1 and Q2, and a secondary on which a voltage is outputted.

In the end, the PWM controller 7 furtehr comprises a voltage feedback loop and a current feedback loop, denoted by reference numerals 13 and 14, respectively, which are respectively connected between the buffer power supply line 8 and a current feedback input, denoted by i_Ref, and a voltage feedback input, denoted by CTR_Ramp, of the PWM controller 7, and each of which is formed by a resistor and a PNP transistor series-connected between the buffer power supply line 8 and the respective feedback input.

During the Low_Side phase, i.e. when the Low_Side drive signal is high, the electric current flowing through the primary of the transformer 11 generates a primary voltage $V_0$ across the terminals of $L_{prim}$, equal to $V_0 = di_{Lprim}/dt * L_{prim}$; the electrc energy in the primary of the transformed 11 is transferred to the secondary of the transformer 11, thereby generating a secondary voltage, which is a function of the turns ratio of the transformer 11. In the High_Side phase, namely when the High_Side drive signal is high, the High_Side drive signal causes the primary of the transformer 11 to be short-circuited to earth, so as to keep its energy as long as possible and, at the same time, charge the buffer capacitor Cx, which has the function of an energy storage device, with the current *is*.

As shown in Figure 9, which shows the temporal trend of the buffer voltage Vm across the terminals of the buffer capacitor Cx, it can be seen how the electric energy is stored in the buffer capacitor Cx, which cannot be dissipated on the load as it varies abruptly, generating an overvoltage with respect to that of the primary power supply, generated by the electric current $i_s$.

The step denoted in Figure 9 by "eng" precisely represents the electric energy $E = \frac{1}{2} * Cx * V^2$ recovered in the buffer capacitor Cx and that will then be reinjected into the driving force circuit in the next cycle. The cycle is controlled by the buffer voltage Vm across the terminals of the buffer capacitor Cx, acting on the ramp control and, at the same time, on the set voltage reference, which serves to avoid instability during transitions.

The buffer voltage Vm that is generated can be less than the input voltage at which the power supply input line 12 is set: in this case, a short-circuit to the load has occurred, and therefore the reaction of Q2 causes the switching off of the PWM with a pulse the shape of which is the derivative of the voltage Vm signal that is generated on the buffer power supply line.

When voltage Vm is less than or equal to the voltage Vin, energy recovery does not occur, whilst when the voltage Vm is greater than the voltage Vin, energy recovery is activated, with energy transfer from the buffer capacitor Cx to the load, which will be equal to half of the stored energy E.

The output of the SAP board 3 is completely floating with respect to the earth node. In this way, the quite strict regulations in terms of safety, necessary as the maximum voltage of the output modulator can reach i 1.2KVpp, with peak power exceeding 300 Watt, are respected.

### 3. CPU-ARM controller

Operation of the geoelectrical prospection apparatus is controlled by an ARM Cortex-M3 processor-based CPU 4 optimized to curb electric power consumption and provide high computational performance.

The CPU 4 is designed to control the various subsystems, exception handling, and also the connection with the outside via commonly used communications protocols.

Development of the novel firmware was carried out in accordance with a hierarchical and modular architectural pattern, in order to facilitate coding and obtain a desired functional decoupling between the various levels of hardware management and consequent ease in handling exceptions. The implementation i) of a minimal cooperative operating system, ii) with direct control of the hardware lines with critical timing, and robust statistical calculation of the potential differences on the measuring electrodes, enable reliable and optimized operation from the standpoints of management and the computational power necessary for the implementation.

With regard to the cooperative operating system, this envisages that management of the geoelectrical prospection apparatus is carried out by independent modules that are executed sequentially. Each module controls a specific hardware subsystem in a functionally isolated manner and processes the state change of the hardware it controls on the basis of available and previously processed parameters, resulting in the updating of the parameters within its competence (output) so as to make them available for the processing of the successive module (input).

The list of the modules that require processing is dynamic, with registration and de-registration managed via global variables; excluding exception interrupts, the module currently in execution has total control of the CPU for the minimum time needed.

With regard to managing critical timings, this concerns two aspects: driving the control voltages of the power bridge for current injection and reading the analog-to-digital conversion registers.

With regard to driving the power bridge's control voltages, the timing problem resides in ensuring that the minimum switching times are respected in order to avoid race conditions in the final stage. Meeting the minimum time requirement is easily handled by the software module that controls the bridge's subsystem. Based on this consideration, the problem is moved from time management to state management, making the direct driving of the bridge's hardware lines compatible with the performance offered by the cooperative operating system.

With regard to reading the analog-to-digital conversion registers, the timing problem resides in avoiding that the device assigned to the conversion loses the current register content in order to make space for a new conversion value. This timing problem is handled by taking certain measures: leaving the ADC management module always included on the list of active modules, raising its execution priority when the event that signals the arrival of new available data occurs, and adding control for the state of possible overwriting of the conversion register. The detection of any overwriting generates an exception, which is then handled by software.

In the end, with regard to the robust statistical calculation of the potential differences on the measuring electrodes, the apparent resistivity value required by the geoelectrical inversion programs is the ratio between induced polarization voltage and injection current, which is obtained from the signals present at the AD converters' inputs. In order to limit noise, it is opportune to take the average of the instantaneous values to which a reduction in variance theoretically equal to the number of averaged samples corresponds. However, it is noted that the arithmetic average is not a statistically robust estimator, in the sense that it is strongly influenced by the presence of outliers. A robust estimator is instead represented by the median, the computation of which entails, on one hand, the need to conserve all the values of the analog samples and, on the other, to use a quick sorting algorithm (qsort). The development of the data processing module has been organised for computation of the median and implementation of the qsort algorithm (binary sort with complexity n*log(n)). Implementation of the qsort algorithm enables achieving processing times that are compatible with the performance of the mini cooperative operating system for all envisaged sampling time periods.

From that described above, the novelty and inventive scope of the synergetic combination of the characteristics of the geoelectrical prospection apparatus according to the present invention will be immediately evident to an expert in the field. In particular, the present invention allows improving the sensitivity of geoelectrical prospection apparatuses and reducing the number of components, consequently reducing the cost of manufacturing.

**Claims**

1.   A geoelectrical prospection apparatus (1) comprising:

   - current electrodes (A, B) and voltage electrodes (M, N) adapted to be arranged in contact with a medium;
   - an electric power supply device (3), to which the current electrodes (A, B) are selectively connected so as to be electrically powered and to inject an electric current into the medium;
   - a measurement device (2), to which voltage electrodes (M, N) are selectively connected to measure and analogical-to-digital convert geoelectrical measurements defined by differences V(i,j) between the electric potentials of the voltage electrodes (M, N) connected to the measurement device (2) and induced by the electric current injected into the medium by the current electrodes (A, B) connected to the electric power supply device (3); and
   - an electronic control unit (4) connectable to the electric power supply device (3) and to the measurement device (2) to control the operation of the electric power supply device (3) and to receive, from the measurement device (2), and process the electric potentials of the voltage electrodes (M, N) connected to the measurement device (2) to determine a geoelectrical model of the medium;
   the measurement device (2) comprises an analog-to-digital converter (5) having an analog front-end input configured to receive the electric potentials of the voltage electrodes (M, N), connected to the measurement device (2), and to be supplied with a power supply electric potential (+V) with respect to a reference electric potential (Vcom);
   the geoelectrical prospection apparatus (1) is **characterized in that** the measurement device (2) is configured to supply the analog front-end input of the analog-to-digital converter (5) with the electric potentials of the voltage electrodes (M, N) connected to the measurement device (2) so as to result in the reference electric potential (Vcom) being floating with respect to electric potentials induced between the voltage electrodes (M, N), whereby the difference V (i,j) between the electric potentials induced between any of two voltage electrodes i and j is equal to:

$$V(i,j) = V(i,com) - V(j,com)$$

   where V(i,com) is the difference between the electric potential of the voltage electrode i and the reference potential V(com), and V(j,com) is the difference between the electric potential of the voltage electrode j and the reference potential V(com), which resultingly fails to intervene in the determination of the difference V(i,j) between the electric potentials of the voltage electrodes i and j.

2.   The geoelectrical prospection apparatus according to claim 1, wherein the analog-to-digital converter (5) comprises a plurality of analog-to-digital conversion units connected to the analog front-end to simultaneously analog-to-digital convert the electric potentials of a corresponding plurality of voltage electrodes (M, N) supplied by the measurement device (2).

3.   The geoelectrical prospection apparatus according to claim 2, wherein the measurement device (2) is further configured to selectively supply the analog-to-digital conversion units with the electric potentials of the voltage electrodes (M, N) connected to the measurement device (2) in a sequential manner and with a modularity expressed by a number that is relatively prime to the number of analog-to-digital conversion units.

4. The geoelectrical prospection apparatus according to any one of the preceding claims, wherein the electric power supply device (3) is configured to supply the current electrodes (A, B) with an electric voltage that is stabilized with respect to load variations by means of a pulse width modulation (PWM).

5. The geoelectrical prospection apparatus according to claim 4, wherein the electric power supply device (3) comprises a PWM controller (7) in an "active clamp" configuration.

6. The geoelectrical prospection apparatus according to claim 5, wherein the PWM controller (7) is configured to output two square wave drive signals (High_Side, Low_Side) supplied to the control terminals of two pull-up and pull-down output transistors (Q1, Q2), respectively, series-connected between a buffer power supply electric potential (Vm) and the reference electric potential (Vcom);
the PWM controller (7) in an "active clamp" configuration further comprises a buffer capacitor (Cx) connected between the buffer power supply electric potential (Vm) and the reference electric potential (Vcom); a current measuring circuit (10) series-connected between the two output transistors (Q1, Q2) to measure the current flowing therebetween and feed it back to the PWM controller (7); a transformer (11) having a primary connected between a power supply electric potential (Vin) and a common node between the two output transistors (Q1, Q2), and a secondary coupled to the primary to provide an output voltage; and a current feedback branch (13) connected between the buffer power supply electric potential (Vm) and a current feedback input (i_Ref), and a voltage feedback branch (14) connected between the buffer power supply electric potential (Vm) and a voltage feedback input (CTR_Ramp) of the PWM controller (7); wherein each one of the current and voltage feedback branches (13, 14) comprises a series-connected resistor and transistor;
whereby, when the pull-down transistor (Q2) is in current conduction, an electric current flows between the power supply electric potential (Vin) and the reference electric potential (GND), flowing through the pull-down transistor (Q2) and the primary of the transformer (11), thereby generating, across the terminals of the primary of the transformer (11), a voltage that is transferred to the secondary of the transformer (11),, while when the pull-up transistor (Q1) is in current conduction, an electric current ($i_S$) flows between the power supply electric potential (Vin) and the buffer electric potential (Vm), flowing through the buffer capacitor (Cx) and the pull-up transistor (Q1), thereby causing an electric energy to be stored in the buffer capacitor (Cx), and which will then be discharged into the circuit in the successive cycle.

7. The geoelectrical prospection apparatus according to any one of the preceding claims, wherein the electronic control unit (4) comprises a cooperative operating system designed to manage the geoelectrical prospection apparatus (1) by means of independent modules that are sequentially executed to control, each, a specific hardware subsystem in a functionally isolated manner and processes the change in the status of the hardware controlled thereby based on available and previously processed parameters, so resulting in the relevant parameters being updated and made available to the the successive module for processing.

FIG. 1

FIG. 2

FIG. 3

FIG. 4A

FIG. 4B

EP 3 316 005 A1

FIG. 5A

FIG. 5B

EP 3 316 005 A1

OUT

R305 R94 R313

R96

12V VDD

12V VSS GND

C107

Select_x5

C101 C104

12V -12V

R93 R95

FIG. 6

12V -12V

Reset_Bias

R92 C106 DB DA

D29 +A OUT 6 ABI R97

D28 12V 12V

R91

C102

R90 220k

R89 220k

R89 220k

C103

Shield

IN

FIG. 7

EP 3 316 005 A1

FIG. 9

FIG. 8

Europäisches
Patentamt

European
Patent Office

Office européen
des brevets

**EUROPEAN SEARCH REPORT**

Application Number

EP 17 19 8405

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2014/218037 A1 (SLATER LEE [US] ET AL) 7 August 2014 (2014-08-07) * abstract; figures 2,3 * * paragraphs [0003], [0018], [0021], [0022], [0025], [0029], [0030], [0050] * | 1 | INV. G01V3/02 H03K17/0814 ADD. G01V11/00 |
| Y<br>A | US 2008/136421 A1 (BRYANT JOHN [US] ET AL) 12 June 2008 (2008-06-12) * abstract; figures 3-6 * * paragraphs [0026], [0027], [0061], [0071], [0078], [0079], [0084], [0090], [0094], [0095], [0130], [0160] * | 1-5,7<br>6 | |
| Y | US 2006/055418 A1 (OGILVY RICHARD D [GB] ET AL) 16 March 2006 (2006-03-16) * abstract; figures 1A,1B * * paragraphs [0029], [0045], [0053] - [0058] * | 1-5,7 | |
| Y | US 2003/122547 A1 (PRAMMER MANFRED G [US]) 3 July 2003 (2003-07-03) * abstract; figure 3 * * paragraphs [0024], [0035] - [0038], [0063]; claim 17 * | 4,5 | TECHNICAL FIELDS SEARCHED (IPC) G01V H03K |
| Y | US 6 614 288 B1 (DAGAN MARC [US] ET AL) 2 September 2003 (2003-09-02) * abstract; figure 6A * * column 8, lines 1-47 * | 5 | |
| A | US 2016/047932 A1 (AKABA HIDEO [JP] ET AL) 18 February 2016 (2016-02-18) * abstract; figure 12 * * paragraphs [0147] - [0150] * | 4,5 | |

-/--

The present search report has been drawn up for all claims

| Place of search | Date of completion of the search | Examiner |
|---|---|---|
| The Hague | 6 March 2018 | de Jong, Frank |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

## EUROPEAN SEARCH REPORT

Application Number

EP 17 19 8405

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2006/186955 A1 (QUILTER PATRICK H [US]) 24 August 2006 (2006-08-24) * abstract; figure 1B * * paragraphs [0059], [0060] * ----- | 4,5 | |
| A | US 6 236 212 B1 (WYNN JEFFREY C [US]) 22 May 2001 (2001-05-22) * column 5, line 59 - column 6, line 6 * ----- | 1 | |
| A | US 2015/346375 A1 (VESSEREAU PATRICK [FR]) 3 December 2015 (2015-12-03) * abstract; figure 3 * * paragraphs [0002], [0028] - [0032] * ----- | 4,5 | |
| | | | **TECHNICAL FIELDS SEARCHED (IPC)** |

The present search report has been drawn up for all claims

| Place of search | Date of completion of the search | Examiner |
|---|---|---|
| The Hague | 6 March 2018 | de Jong, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

## ANNEX TO THE EUROPEAN SEARCH REPORT
## ON EUROPEAN PATENT APPLICATION NO.

EP 17 19 8405

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2018

| Patent document cited in search report | | Publication date | Patent family member(s) | | Publication date |
|---|---|---|---|---|---|
| US 2014218037 | A1 | 07-08-2014 | AU 2013348001 A1 | | 09-07-2015 |
| | | | CA 2930251 A1 | | 30-05-2014 |
| | | | CN 105103008 A | | 25-11-2015 |
| | | | EP 2923226 A1 | | 30-09-2015 |
| | | | US 2014218037 A1 | | 07-08-2014 |
| | | | WO 2014081898 A1 | | 30-05-2014 |
| US 2008136421 | A1 | 12-06-2008 | NONE | | |
| US 2006055418 | A1 | 16-03-2006 | EP 1588193 A1 | | 26-10-2005 |
| | | | US 2006055418 A1 | | 16-03-2006 |
| | | | WO 2004068172 A1 | | 12-08-2004 |
| US 2003122547 | A1 | 03-07-2003 | AR 037955 A1 | | 22-12-2004 |
| | | | CA 2471008 A1 | | 03-07-2003 |
| | | | US 2003122547 A1 | | 03-07-2003 |
| | | | WO 03054585 A1 | | 03-07-2003 |
| US 6614288 | B1 | 02-09-2003 | NONE | | |
| US 2016047932 | A1 | 18-02-2016 | EP 2990813 A1 | | 02-03-2016 |
| | | | JP 6142918 B2 | | 07-06-2017 |
| | | | JP WO2014171342 A1 | | 23-02-2017 |
| | | | US 2016047932 A1 | | 18-02-2016 |
| | | | WO 2014171342 A1 | | 23-10-2014 |
| US 2006186955 | A1 | 24-08-2006 | CN 1805274 A | | 19-07-2006 |
| | | | US 2006186955 A1 | | 24-08-2006 |
| | | | US 2008030268 A1 | | 07-02-2008 |
| US 6236212 | B1 | 22-05-2001 | NONE | | |
| US 2015346375 | A1 | 03-12-2015 | US 2015346375 A1 | | 03-12-2015 |
| | | | WO 2014110328 A1 | | 17-07-2014 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014218037 A1
- US 2008136421 A1
- US 2006055418 A1